# EUROPEAN PATENT APPLICATION

(11) **EP 4 362 651 A1**
(43) Date of publication of application: **01.05.2024**
(21) Application number: 22203733.5
(22) Date of filing: 26.10.2022
(51) Int. Cl.: H10N 60/81, H10N 60/01, G06N 10/40

(54) **ELECTRONIC DEVICE INCLUDING A SUPERCONDUCTING ELECTRONIC CIRCUIT**

(71) Applicant: Infineon Technologies Austria AG, 9500 Villach (AT)
(72) Inventor: BRANDL, Florian, 93142 Maxhuette-Haidhof (DE); BRAUMUELLER, Jochen, 83624 Otterfing (DE)
(74) Representative: Lambsdorff & Lange Patentanwälte Partnerschaft mbB

(57) **Abstract**

A method of manufacturing an electronic device (100) includes generating a superconducting electronic circuit (120) on a substrate (110). Metal oxides from metal surfaces of the superconducting electronic circuit are removed in a process chamber with a substantially oxygen-free environment. At least a portion of the superconducting electronic circuit is covered in situ by hermetic encapsulation (220).

## Description

### Technical Field

This disclosure relates generally to the field of electronic devices, and in particular to electronic devices including a superconducting electronic circuit.

### Background

Electronic devices including a superconducting electronic circuit are used in the art in various technical fields. For example, quantum computing devices operating one or a plurality of superconducting quantum bits (qubits) or transistor-like devices such as, e.g., single flux quantum (SFQ) devices rely on superconducting electronic circuits.

For example, superconducting electronic circuits having a resonating circuit are known as a solid-state approach for implementing quantum computing devices. Qubits (and also other superconducting electronic circuits) generally suffer from two decoherence mechanisms, namely energy relaxation (energy dissipation) and dephasing. In quantum information processing in general and in particular for qubits, decoherence is a major performance detractor.

One main source of decoherence are material defects (two-level-systems, TLS) residing in oxides and other dielectric materials that are fabricated on purpose or form natively on the metal surfaces and interfaces of the device. As these TLS resonate at GHz frequencies (close to or at qubit frequencies, for example), qubits (or other entities operated by the superconducting electronic circuit) can lose energy (and thereby their stored information) by spontaneous energy relaxation into defect modes, leading to a reduction of the average excitation period (e.g. qubit lifetime).

For a fabricated superconducting qubit circuit with defect TLS it has been proposed previously to manipulate surface defects by applying a DC electric field to detune the resonance frequencies of defects away from the qubit frequency and thereby decrease their impact on qubit coherence. However, TLS cannot be addressed individually such that a controlled manipulation of a large number of TLS with distributed frequencies is not feasible.

### Summary

According to an aspect of the disclosure, a method of manufacturing an electronic device comprises generating a superconducting electronic circuit on a substrate. Metal oxides (which form natively on metal surfaces when exposed to atmosphere) are removed from metallizations of the superconducting electronic circuit in a process chamber with a substantially oxygen-free environment. At least a portion of the superconducting electronic circuit is in situ enclosed in a hermetically sealed hollow space.

According to another aspect of the disclosure, an electronic device comprises a substrate and a superconducting electronic circuit formed over the substrate. A lid encloses at least a portion of the superconducting electronic circuit in a hermetically sealed hollow space.

### Brief description of the drawings

The elements of the drawings are not necessarily to scale relative to each other. Like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1 is a schematic top view of an exemplary electronic device having a lid covering the entire superconducting electronic circuit.
Figure 2 is a schematic cross-sectional view of the exemplary electronic device along line X-X of Figure 1 with a lid attached to the substrate.
Figure 3 is a schematic top view of an exemplary electronic device having a lid covering a portion of the superconducting electronic circuit.
Figure 4 is a flowchart illustrating exemplary stages of a method of manufacturing an electronic device.
Figures 5A-5B are schematic sectional views of providing and processing an exemplary lid wafer.
Figure 6 is an illustration of manufacturing stages for bonding a lid wafer to a substrate.
Figure 7 is a schematic cross-sectional view of a lid wafer bonded to a substrate for generating a plurality of electronic devices by singulation.
Figure 8 is a schematic top view of an exemplary electronic device covered by a lid, wherein the top of the lid is shown transparent and sidewalls and posts of the lid are indicated by dashed lines.
Figure 9 is a schematic cross-sectional view of the exemplary electronic device along line Y-Y of Figure 8 with a sacrificial material disposed on the superconducting electronic circuit.
Figure 10 is a schematic cross-sectional view of the exemplary electronic device of Figure 9 after the sacrificial material has been removed.
Figure 11 is a schematic cross-sectional view of an exemplary electronic device including a plurality of superconducting electronic circuits arranged aside each other.
Figure 12 is a schematic cross-sectional view of an exemplary electronic device including a plurality of stacked superconducting electronic circuits.
Figure 13 is a schematic cross-sectional view of another exemplary electronic device including a plurality of stacked superconducting electronic circuits.

### Detailed description

The words "over" or "beneath" with regard to a part, element or material layer formed or located or disposed or arranged or placed "over" or "beneath" a surface may be used herein to mean that the part, element or material layer be located (e.g. placed, formed, arranged, disposed, etc.) "directly on" or "directly under", e.g. in direct contact with, the implied surface. The word "over" or "beneath" used with regard to a part, element or material layer formed or located or disposed or arranged or placed "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

The following description relates by way of example to an electronic device representing a quantum computing device. However, the disclosure herein is not limited to quantum computing devices. Rather, the disclosure basically covers all electronic devices which include a superconducting electronic circuit.

The superconducting electronic circuit disclosed herein may, e.g., be a superconducting quantum circuit. In this case, the electronic device described herein may be referred to as a superconducting quantum device.

In one example, the superconducting electronic circuit may, e.g., comprise or be a resonating circuit. A resonating circuit typically comprises (at least) a capacitor and an inductor. The resonating circuit can be a linear resonating circuit (e.g. harmonic oscillator) or a nonlinear resonating circuit (e.g. anharmonic oscillator). In quantum devices such resonating circuits are also referred to as quantum oscillators (QO) .

A known technique is to use a Josephson junction to provide a non-linear inductor to make a resonating circuit nonlinear (or, differently stated, the oscillator potential anharmonic). In quantum computing devices, quantum anharmonic oscillators are used to "form" qubits. Differently put, a nonlinear resonating circuit may "form" (or operate) a qubit. Qubits created by one or more (nonlinear) Josephson junctions in a (thus nonlinear) resonating circuit are sometimes also referred to as "Josephson qubits" in the art.

Other examples of electronic devices including a superconducting electronic circuit are single flux quantum (SFQ) devices. Such devices are transistor-like devices in which voltage pulses produced by Josephson junctions in the superconducting electronic (quantum) circuit (instead of the voltage levels produced by transistors in semiconductor electronics) are used to encode, process, and transport digital information.

That is, a superconducting electronic circuit as disclosed herein may, e.g., include a Josephson junction. In this case, the Josephson junction may be the "active element" of the superconducting electronic circuit. With a view to quantum computing, as mentioned above, the Josephson junction provides for the nonlinearity of the resonating circuit, rendering the resonating circuit operable to form a qubit. With a view to SFQ, as mentioned above, the Josephson junction provides for voltage pulses. Superconducting electronic circuits (or devices) using a Josephson junction are examples of superconducting quantum circuits (or devices), since the Josephson effect is based on a quantum mechanical tunneling process.

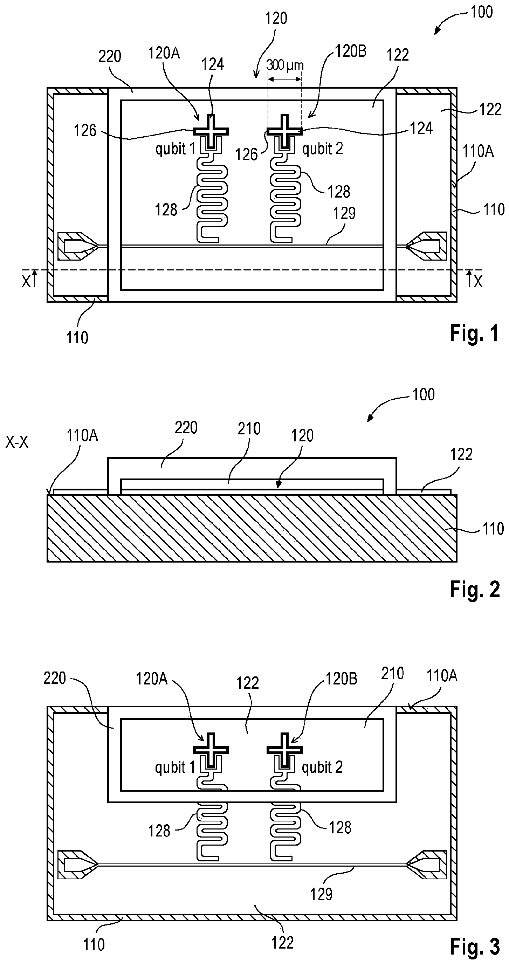

Referring to Figure 1, an exemplary electronic device 100 includes a substrate 110. A superconducting electronic circuit 120 is formed over (e.g., on) the substrate 110. The superconducting electronic circuit 120 implements a quantum circuit. In the specific example of Figure 1 two superconducting qubits (qubit 1 and qubit 2) are formed by the superconducting electronic circuit 120.

A superconducting qubit is formed from resonant modes in a nonlinear electric circuit 120A (for qubit 1) and 120B (for qubit 2). Each nonlinear electric circuit 120A, 120B (which are resonating circuits) may be formed from superconducting inductors, capacitors, and Josephson junctions. A qubit, as disclosed herein, may be based on electric charge (so-called charge qubit) or on magnetic flux (so-called flux qubit). Other modalities of qubits, such as, e.g., phase qubits, are also possible. Further, variations of the above-mentioned qubit modalities such as, e.g., transmon qubits and/or fluxonium qubits are superconducting qubits in accordance with this disclosure.

Other electronic devices that also include (different) superconducting electronic circuits formed on a substrate 110 are, e.g., SFQ devices.

In Figure 1 and throughout the following description, by way of example and without restriction of generality, qubits are exemplified by transmon qubits or, more specifically, Xmon qubits. However, the disclosure herein generally relates, inter alia, to all types or modalities of superconducting qubits and quantum devices formed by nonlinear electric circuits such as, e.g., nonlinear electric circuits 120A, 120B.

The substrate 110 may, e.g., comprise or be a sapphire substrate or a silicon substrate, in particular high-resistive crystalline silicon. The substrate 110 forms the carrier for the superconducting electronic circuit 120. More specifically, the superconducting electronic circuit 120 may comprise a superconducting material layer 122 disposed on a surface 110A of the substrate 110. The superconducting material layer 122 may be structured to form components of the nonlinear electric circuits 120A, 120B representing qubit 1 and qubit 2, respectively. For example, the entire superconducting electronic circuit 120 may be formed by the structured superconducting material layer 122.

For example, each nonlinear electric circuit (or qubit) 120A, 120B may include a capacitor electrode 124 and a Josephson junction 126 connecting the capacitor electrode 124 to the superconducting material layer 122. The capacitor electrode 124 may, for example, be formed as an X-shaped island structured out of the superconducting material layer 122. The capacitor electrode 124 may, for example, have a lateral dimension of about 300 µm.

Similarly, resonators 128 may be patterned from the superconducting material layer 122 by a subtractive fabrication process. Each capacitor electrode 124 may capacitively couple to a resonator 128, which couples to a feedline 129 (e.g. in a frequency multiplexed readout scheme).

The feedline 129 may also be, e.g., formed by an island structure patterned out of the superconducting material layer 122. In other words, all components of the nonlinear electric circuits 120A, 120B together with the readout circuitry may be structured out of a single common superconducting material layer 122.

The resonator 128, which is capacitively coupled to a respective qubit (qubit 1 or qubit 2), is sometimes referred to as a readout resonator in the art.

The superconducting material layer 122 may, e.g., be grounded. For that reason the superconducting material layer 122 is sometimes referred to as the ground plane of the nonlinear electric circuits 120A, 120B or, in other words, of qubit 1 and qubit 2, respectively. The superconducting material layer 122 may, e.g., comprise or be of Al, Nb or Ta.

Figure 2 illustrates a sectional view of the electronic device 100 along sectional line X-X of Figure 1. In Figure 2 at least a portion of the superconducting electronic circuit 120 included in a hermetically sealed hollow space (or cavity) 210.

For example, the hermetically sealed hollow space 210 in which at least a portion of the superconducting electronic circuit 120 is located may be defined by a lid 220. The portion of the semiconductor electronic circuit 120 which is included in the hermetically sealed hollow space 210 (e.g. covered by the lid 220) remains completely exposed, i.e. is not in contact with any (dielectric) encapsulation material (e.g. the lid 220).

Figure 1 shows only the sidewalls of the lid 220 so that the view of the superconducting electronic circuit 120 is not obstructed by the lid 220. For example, the lid 220 may hermetically seal to the substrate 110. In other examples, the lid 220 may seal to intermediate structures (not shown) arranged between the substrate 110 and the lid 220.

The lid 220 may comprise or be of sapphire or glass or a semiconductor material such as, e.g., silicon. The lid 220 may, e.g., be of the same material as the substrate 110. In other examples the lid 220 may comprise or be of a metal material such as, e.g., copper or aluminum and/or the same material as the superconducting material layer 122.

Returning to Figure 1, the lid 220 may cover the nonlinear electric circuit(s) 120A, 120B, i.e. qubit 1 and/or qubit 2, and the corresponding readout circuitry which is, in this example, exemplified by resonator(s) 128 and feedline 129. For example, the lid 220 may cover the entire superconducting electronic circuit 120, i.e., a plurality of qubits, and a portion or the entirety of their associated readout circuitry.

In other examples, referring to Figure 3, a "local" hermetically sealed hollow space 210 may be provided by, e.g., a lid 220 which may be designed as a "local" lid. In this case, the lid 220 may only cover a portion of the superconducting electronic circuit 120, e.g. only the nonlinear electric circuit(s) 120A, 120B, e.g. qubit 1 and/or qubit 2. The readout circuitry, here exemplified by readout resonator(s) 128 and feedline 129, may at least partly be outside of the lid 220 (or, more generally, outside the hermetically sealed hollow space 210). In other words, only the qubits may be located in the hermetically sealed hollow space 210 (e.g. by being covered by the lid 220), while readout circuitry may be kept outside the hermetically sealed hollow space 210 formed between the lid 220 and the substrate 110, for example.

Still further, it is possible that the capacitor electrode 124 of the superconducting electronic circuit 120 is included in the hermetically sealed hollow space 210 (defined, e.g., by the lid 220), while other portions of the nonlinear electric circuit(s) 120A, 120B such as, e.g., the Josephson junctions 126 and/or additional inductors (if any) are outside the hermetically sealed hollow space 210.

As mentioned above, superconducting qubits suffer from energy dissipation caused by atomic-scale defects in device materials. A known host of such defects are metal oxides formed on metal surfaces of the superconducting electronic circuit 120.

More specifically, the superconducting material layer 122 oftentimes is a metal that forms a native oxide when exposed to atmosphere, such as aluminum which forms a native aluminum oxide. Oxide layers, which host TLS, are formed on all surfaces of the superconducting material layer 122 and, in particular, on the qubit capacitor electrodes 124. The TLS couple via their electric dipole moment to the oscillating electric field in the nonlinear electric circuit(s) 120A, 120B and are thereby limiting the coherence of the electronic device 100.

As mentioned earlier, this adverse effect of oxide layers on surfaces of superconducting materials is not limited to quantum computing devices, but is also evident in other devices that use superconducting electronic circuitry, in particular superconducting quantum circuitry.

A passivation (oxidation stop) is currently not a solution to this problem, since there are no known dielectric materials that are free of such defects and can readily be deposited in situ, e.g., by sputtering or evaporation to avoid oxidation of the metal surfaces of the superconducting electronic circuit 120 (e.g. of the superconducting material layer 122 in the examples shown).

A conventional work-around for this problem is to reduce the electric field in the electronic device 100 as much as possible in order to reduce the coupling of superconducting qubits to parasitic TLS. However, this implies large structures, e.g. capacitors with large gaps between the electrodes. This results in a large footprint (area consumption) per individual qubit and favors unwanted cross-talk between qubits as electric fields are less localized.

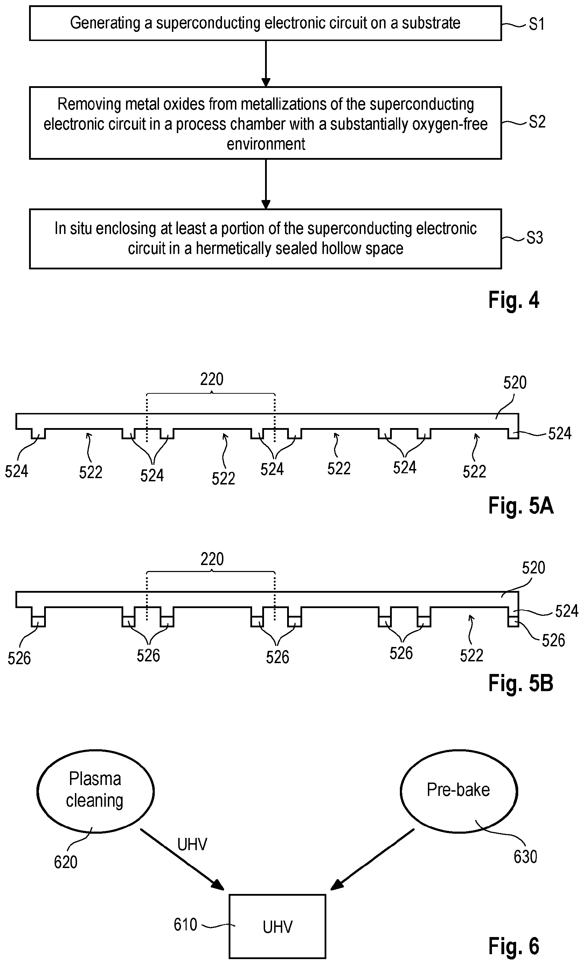

Figure 4 illustrates stages of an exemplary method of manufacturing an electronic device in accordance with the disclosure. By applying this method, the oxide layer thickness and thus the occurrence of defects (e.g. TLS) can be greatly reduced by, e.g., order(s) of magnitude. As a consequence, losses due to defect states (e.g. resonant interactions with fluctuating TLS) are expected to decrease by order(s) of magnitude.

At S1 a superconducting electronic circuit 120 is generated on a substrate 110. The superconducting electronic circuit 120 may, e.g., form at least one qubit, e.g. qubit 1 and/or qubit 2.

At S2 metal oxide is removed from metallizations (e.g. the superconducting material layer 122) of the superconducting electronic circuit 120 in a process chamber with a substantially oxygen-free environment (i.e. an environment having an extremely low residual partial oxygen pressure, e.g. vacuum). The removal of the metal oxides may comprise plasma etching, HF vapor application or wet etching.

Then, at S3, at least a portion of the superconducting electronic circuit 120 is enclosed in a hermetically sealed hollow space. The hermetically sealed hollow space may, e.g., be provided by a lid 220 hermetically sealed to the substrate 110, for example. S3 is carried out in situ, i.e. without breaking the substantially oxygen-free environment (e.g. vacuum) applied at S2 during metal oxide removal. That way, the oxygen partial pressure of the environment can be kept low to avoid new formation of metal oxides after their removal from the metallizations of the superconducting electronic circuit 120.

For example, throughout the whole period between the removal of the metal oxides (at S2) and the formation of the hermetically sealed hollow space (e.g. the sealing of the lid to the substrate) at S3, the oxygen partial pressure inside the process chamber may be equal to or less than 10⁻⁷ or 10⁻⁸ mbar.

For small oxygen partial pressures and small exposure times the relevant parameter that determines oxide growth is the exposure (or dosage) p(O₂) × t, where p(O₂) denotes the oxygen partial pressure and t is the exposure time.

For aluminum, the oxide thickness saturates at long exposure times t and is only a function of the oxygen partial pressure p(O₂). Table 1 specifies the saturated oxide layer thickness (with 1 Torr = 1.3 mbar and 1 Å = 0.1 nm). The quantities specified in Table 1 relate to AlOx oxide layer formation on an Al metallization.

**Table 1 (quoted from N. Cai, G. Zhou, K. Muller, et al. PRL 107, 035502, (2011))**

| | | | | | | | |
|---|---|---|---|---|---|---|---|
| Partial Pressure (Torr) | 1×10⁻⁸ | 1×10⁻⁷ | 1×10⁻⁶ | 1×10⁻⁵ | 1×10⁻² | 1 | 5 |
| Limiting oxide thickness (Å) | 2.42 | 3.81 | 5.14 | 5.99 | 11.30 | 12.42 | 12.43 |

For example, oxide layer thickness saturates at about 1.2 nm at about 1 mbar. Further increasing the oxygen partial pressure p(O₂) does not result in thicker oxide layers. On the other hand, at p(O₂) of 10⁻⁸ mbar, a saturated oxide layer thickness of 0.24 nm is to be expected. In this case the thickness of the oxide layer is reduced by at least a factor of five. An oxygen partial pressure p(O₂) of, e.g., 10⁻⁸ mbar or less is realistic in, e.g., a N₂-purged chamber of 10⁻⁶ mbar background pressure.

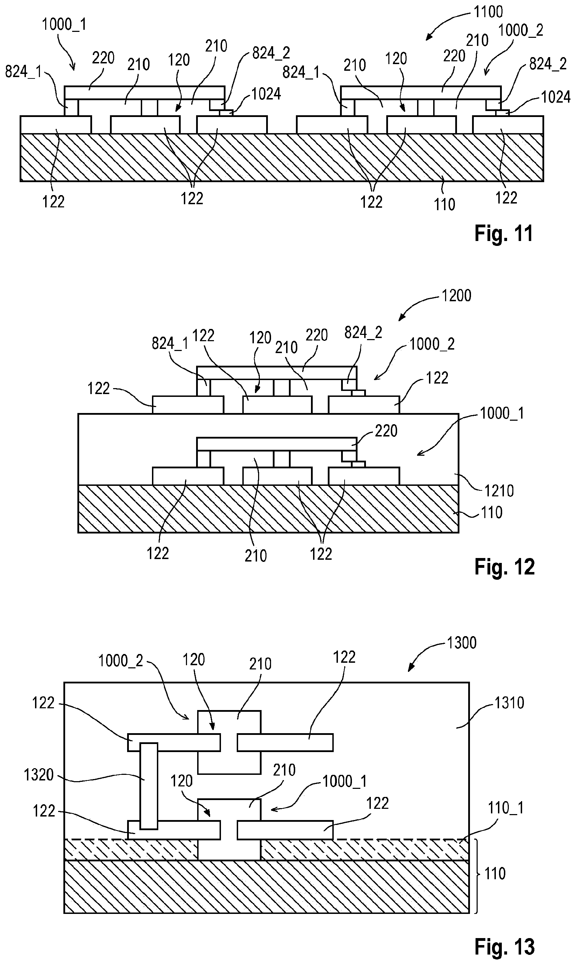

As a result of the reduction of the thickness of the metal oxide layer, the occurrence of defects (e.g. TLS) can be reduced. As a consequence, electric fields in the superconducting electronic circuit 120 may be increased without a penalty in decoherence. This allows to narrow the footprint of single qubits. Therefore, the lateral dimensions of the entire superconducting electronic circuit 120 can be made significantly smaller. This supports integration concepts with dense packaging in horizontal and/or vertical dimensions, in particular multilayer packing as disclosed further below in conjunction with Figure 12. Further or alternatively, increased coherence times of qubits are expected. Differently stated, the removal of oxides and/or encapsulate reduces dielectric loss and ultimately improves the quality of resonating circuits and/or qubit lifetimes.

The lid 220 may either be formed individually or it is possible to provide a lid wafer comprising a plurality of integral lids. Figure 5A illustrates an example of a lid wafer 520. The lid wafer 520 may, e.g., comprise or be of glass or silicon. Dotted lines in Figure 5A illustrate the outline of a single lid 220, which is integrally contained in the lid wafer 520.

The optional stage of forming a lid wafer 520 may include structuring the lid wafer 520 to form recesses 522 and sidewalls 524 of the lids 220 integrated in the lid wafer 520. Structuring of the lid wafer 520 may involve lithographic patterning and etching the lid wafer 520.

Referring to Figure 5B, a bonding material 526 may be applied to the end faces of the sidewalls 524. The bonding material may be a material appropriate for wafer bonding. For example, the bonding material 526 may be glass frit. The bonding material 526 may, e.g., be applied to the end faces of the sidewalls 524 of the recesses 522 by, for example, screen printing, in particular silk screen printing. In other examples, the bonding material 526 may, e.g., be applied over the substrate 110 on, e.g., the superconducting material layer 122.

Referring to Figure 6, the lid wafer 520 or a diced-out portion of the lid wafer 520 (e.g. a tile of the lid wafer 520 containing a subset of the plurality of lids 220 integrated in the lid wafer 520) is then introduced in a bonding tool 610. The bonding tool 610 is configured to achieve a chamber atmosphere (environment) with very low residual oxygen partial pressure, e.g. UHV (ultra high vacuum) or protective gas (e.g. N₂, 4He, ...) atmosphere.

Further, the bonding tool 610 may be used for processing the substrate 110. Processing the substrate 110 includes removing metal oxides from metallizations of the superconducting electronic circuit(s) 120 in vacuum, e.g. UHV. The oxide may be removed, e.g., by plasma cleaning 620 or a wet etching process. After removal of the oxides from the substrate 110 e.g. within or in vacuum communication with the bonding tool 610, the lid wafer 520 or the diced-out portion of the lid wafer 520 is bonded to the substrate 110.

By bonding the lid wafer 520 to the substrate 110, the recesses 522 are hermitically sealed by the corresponding lid 220 and, e.g., the substrate 110 to form the hermetically sealed hollow spaces 210. Importantly, after removing the metal oxide from the metallizations of the superconducting electronic circuits 120, the vacuum (e.g. UHV) is not broken until the recesses 522 are hermetically sealed. That way, the partial oxygen pressure p(O₂) can be kept low during the whole period between the removal of the metal oxides and the hermetical closure of the hollow spaces (cavities) 210 by the lids 220. This in situ processing excludes or greatly minimizes any native oxide formation on the metallization after oxide removal.

Optionally and depending on the bonding material 526 used, the process may further comprise a stage of pre-baking the lid wafer 520 to remove organic solvents from the bonding material 526, e.g. from the glass frit material. The pre-baking at 630 can also be carried out in the bonding tool 610.

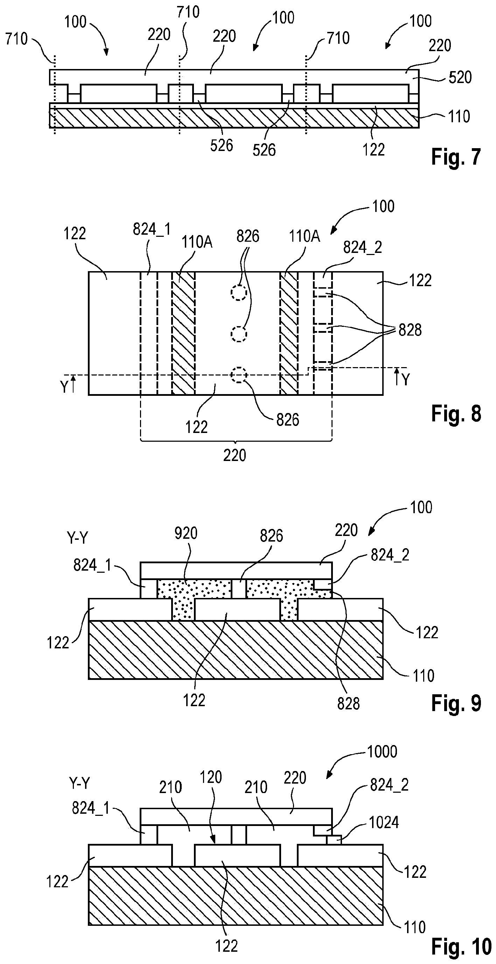

Referring to Figure 7, the bonded-together lid wafer 520 or diced-out portion of the lid wafer 520 and the substrate 110 may be diced along dicing lines 710 to singulate a plurality of electronic devices 100.

It is to be noted that each lid 220 may cover one or a plurality of nonlinear electric circuits 120A, 120B, as shown in Figure 1, or in particular the capacitor electrode 124 regions thereof. Further, the substrate 110 of Figure 7 may be composed of a plurality of substrates 110 as shown in Figure 1, e.g. may be a substrate wafer. Differently stated, the substrate 110 of Figure 1 may be formed by dicing a substrate wafer 110 of Figure 7, wherein the substrate wafer 110 may be provided with an array of the superconducting material layers 122 as shown in Figure 1.

Figures 8 to 10 illustrate an exemplary electronic device 1000. Referring to Figures 8 and 9, similar as described above, a superconducting material layer 122 is deposited over a substrate 110 and structured to form separate metallizations of the superconducting electronic circuit 120 (and thereby to expose areas of the surface 110A of the substrate 110). The superconducting electronic circuit 120 of Figures 8 and 9 may be identical with the superconducting electronic circuit 120 described above, and reference is made to the above description to avoid reiteration. In Figure 8, the top of the lid 220 is shown transparent to reveal the underlying structured superconducting material layer 122.

A sacrificial material 920 is formed over (e.g., on) the superconducting electronic circuit 120. The sacrificial material 920 may, e.g., comprise or be of silicon oxide, carbon, etc.

Sidewalls 824_1, 824_2 and (optionally) posts 826 are formed in the layer of sacrificial material 920. The sidewalls 824_1, 824_2 and posts 826 are of a different material than the sacrificial material 920. It is possible that the sidewalls 824_1, 824_2 and the (optional) posts 826 are formed before the lid 220 is deposited on top of the layer of sacrificial material 920. In other examples, corresponding hollow structures may be provided as recesses or trenches in the layer of sacrificial material 920, and these hollow structures are filled by a specific deposition process or during the deposition of the lid material forming the lid 220. The positions of the sidewalls 824_1, 824_2 and the (optionally) posts 826 are depicted in the plan view of Figure 8 by dashed lines. Further MEMS (micro-electro-mechanical systems) techniques may also be applied.

The lid material may be deposited over the sacrificial material to form a lid layer. The lid layer may then be structured to form the lid(s) 220. Optionally, the layer of sacrificial material 920 may be structured to remove sacrificial material 920 outside the sidewalls 824_1, 824_2 (see Figure 9).

The material of the lid 220 (including its sidewalls 824_1, 824_2 and optional posts 826) is different from the sacrificial material 920. For example, the material of the lid 220 comprises or is of polysilicon, metal, or silicon oxide (silicon oxide only if the sacrificial material 920 is not of silicon oxide).

As shown in Figures 8 and 9, while the sidewall 824_1 may, e.g., be continuous, the sidewall 824_2 may be provided with one or more openings 828. In other examples, multiple or all sidewalls 824_1, 824_2 are provided with at least one opening 828. Generally, at least one opening 828 may, e.g., be provided in the sidewalls 824_1, 824_2. The sidewalls 824_1, 824_2 may correspond to sidewalls 524 shown in Figure 5. Additionally or alternatively, the lid 220 may be provided with an opening (not shown).

The sacrificial material 920 is then removed by a suitable process via the one or more openings (e.g. holes) 828. For example, removal of the sacrificial material 920 may comprise the application of HF vapor, wet etching, ashing, etc.

In one example removing the sacrificial material 920 and removing the metal oxides from the metallizations of the superconducting electronic circuit 120 may be performed by the same process. For instance, if the etching process can remove both the metal oxide and the sacrificial material 920, the same process may be used for oxide removal from the metallizations and sacrificial material removal. In other examples, removing the sacrificial material 920 and removing the metal oxides from the metallizations of the superconducting electronic circuit 120 is performed by two distinct processes. For instance, if the sacrificial material 920 includes carbon and is removed, e.g., by ashing, two separate processes may be needed for in situ removal of the sacrificial material 920 and the metal oxides.

After removing the metal oxides from the metallizations of the superconducting electronic circuit 120, the at least one opening 828 is closed in situ to hermetically seal the lid 220 with the substrate 110. For example, a suitable closure material 1024 such as, e.g., silicon nitride or silicon oxide may be applied to close the opening(s) 828. Figure 10 illustrates an exemplary electronic device 1000 produced by the described method of forming the lid layer over a layer of sacrificial material 920.

Referring to Figure 11, an electronic device 1100 may comprise a plurality of superconducting electronic circuits 120 or electronic devices 1000 (see Figure 10) arranged aside each other. In other words, the electronic device 1100 may include a plurality of "local" lids 220, wherein each lid 220 may, e.g., cover a portion or the entirety (e.g. only the capacitor electrode, the qubit or the qubit and the readout circuitry) of one or more superconducting electronic circuit(s) 120 (see, e.g., Figures 1 to 3).

A process of manufacturing the electronic device 1100 may be similar to the process described in conjunction with Figures 8 to 10. More specifically, the "local" lids 220 may, e.g., be formed by deposition of the same lid layer on a sacrificial material layer (see Figure 9), wherein the continuous lid layer is then structured into the plurality of lids 220. Subsequently, the sacrificial material 920 is completely removed and the openings 828 are then closed in situ by, e.g., the application of the closure material 1024. Hence, the technique of designing individual lids 220 from a continuous lid layer allows to provide an electronic device 1100 which is easily scalable in the lateral dimension.

Further, this or another technique may also allow to provide for electronic devices which are scalable in the vertical dimension. Figure 12 illustrates a first example of an electronic device 1200 which includes stacked superconducting electronic circuits 120 (or stacked electronic devices 1000 as, e.g., illustrated in Figure 10).

More specifically, a further substrate is disposed over the lid 220 of a first electronic device 1000, which is shown in Figure 12 as the lower electronic device 1000_1. The further substrate may, e.g., be formed by a planarization layer 1210 which is deposited over the lower electronic device 1000_1. The planarization layer 1210 may, e.g., comprise or be of the same material(s) as described above for substrate 110. In other examples, the planarization layer 1210 may, e.g., comprise or be of materials such as, e.g., silicon oxide (SiOx).

The planarization layer 1210 may then be planarized to provide a plane top surface 1210A. Planarization may be carried out e.g. by CMP (chemical-mechanical polishing). The plane top surface 1210A of the planarization layer 1210 may correspond to surface 110A of the substrate 110 in Figures 1 and 2.

Hence, a further superconducting electronic circuit 120 including the superconducting material layer 122 of an upper electronic device 1000_2 is formed on the further substrate (e.g. on the planarization layer 1210). The process described in conjunction with Figures 8 to 10 may then be continued to generate the upper electronic device 1000_2 of Figure 12.

Figure 13 illustrates another example of an electronic device 1300 including a plurality of stacked superconducting electronic circuits 120. In this example, the superconducting electronic circuits 120 are arranged on different levels without using an additional substrate for the upper superconducting electronic circuit 120. Rather, the superconducting electronic circuits 120 may be accommodated in a common material layer 1310. The common material layer 1310 may, e.g., be of the same material than the material(s) described above for the planarization layer 1210, e.g. of SiOx.

The common material layer 1310 may include two hermetically sealed hollow spaces 210 formed, e.g., as encapsulated cavities, in which at least portions of the superconducting electronic circuits 120 are enclosed. The two hermetically sealed hollow spaces 210 (or encapsulated cavities) may be separated by a separating sub-layer of the common material layer 1310. Here, as in all other examples, the superconducting electronic circuits 120 may be electrically connected by an electrical interconnect 1320, such as in the form of vias. Further, here, as in all other examples, the substrate 110 may be a substrate formed of a plurality of different material layers, e.g. of a lower base substrate (e.g. of the material(s) as described above for the substrate 110) and an upper substrate layer 110_1 made of, e.g., the material of the common material layer 1310.

The process of stacking multiple electronic devices 1000, 1000_1, 1000_2 can be repeated numerous times, allowing to arrive at a stacked electronic device 1200 which is scalable in a vertical dimension.

Lateral scalability as illustrated in Figure 11 may be combined with vertical scalability as illustrated in Figure 12. While lateral scalability (i.e. the formation of a plurality of superconducting electronic circuits 120 and lids 220 arranged aside each other) is typically performed in situ (i.e. without breaking the vacuum), vertical scalability may, optionally, include breaking the vacuum between manufacturing of the lower electronic device 1000_1 and the upper electronic device 1000_2.

The electronic devices 100, 1000, 1100, 1200, 1300 disclosed herein may be micro-fabricated devices. That is, some or all parts of the electronic devices 100, 1000, 1100, 1200, 1300 may be formed by micro-fabrication techniques. Generally, micro-fabrication techniques may, e.g., involve photolithography methods (e.g. including photoresist application, patterning, etching) and/or deposition techniques (e.g. chemical vapor deposition (CVD), physical vapor deposition (PVD), sputtering) and/or plating techniques (e.g. electroless plating, galvanic plating) for applying and/or structuring layers. Further, micro-fabrication techniques may include etching processes for structuring photoresist layers, dielectric and/or semiconductor layers (e.g., lid 220) or metal layers (e.g. superconducting material layer 122). As mentioned before, micro-fabrication techniques such as wafer-bonding may also be used (see, e.g., Figure 7).

Further, MEMS (micro-electro-mechanical systems) techniques may be employed in, e.g., the manufacturing processes shown in Figures 7 to 13. In particular, MEMS techniques may be used for lid formation or placement and/or hermetically sealed hollow space formation.

The following examples pertain to further aspects of the disclosure:

Example 1 is a method of manufacturing an electronic device, the method comprising: generating a superconducting electronic circuit on a substrate; removing metal oxides from metallizations of the superconducting electronic circuit in a process chamber with a substantially oxygen-free environment; and in situ enclosing at least a portion of the superconducting electronic circuit in a hermetically sealed hollow space.

In Example 2, the subject matter of Example 1 can optionally include wherein throughout the whole period between the removal of the metal oxides and the in situ enclosing, the oxygen partial pressure of the vacuum is equal to or less than 10⁻⁷ or 10⁻⁸ mbar.

In Example 3, the subject matter of Example 1 or 2 can optionally include wherein removing the metal oxides comprises plasma etching, HF vapour application or wet etching.

In Example 4, the subject matter of any of the preceding Examples can optionally include generating a lid wafer comprising a plurality of integral lids; in situ covering at least the portion of the superconducting electronic circuit by the lid wafer or a diced-out portion of the lid wafer to form the hermetically sealed hollow space; and singulating the electronic device by dicing the lid wafer or diced-out portion of the lid wafer and the substrate.

In Example 5, the subject matter of any of Examples 1 to 3 can optionally include forming a sacrificial material on the superconducting electronic circuit; forming a lid layer on the sacrificial material; removing the sacrificial material via at least one opening leading into the space between the substrate and the lid layer; and, after removing the metal oxides from the metallizations of the superconducting electronic circuit in the vacuum, closing the at least one opening in situ to provide the hermetically sealed hollow space.

In Example 6, the subject matter of Example 5 can optionally include wherein removing the sacrificial material and removing the metal oxides is performed by the same process.

In Example 7, the subject matter of Example 5 or 6 can optionally include depositing a planarization layer over the lid layer and the substrate; planarizing the planarization layer; and manufacturing a further electronic device over the planarization layer.

In Example 8, the subject matter of Example 7 can optionally include wherein the planarization layer is used as the substrate of the further electronic device.

Example 9 is an electronic device including a substrate; a superconducting electronic circuit formed over the substrate; and a lid enclosing at least a portion of the superconducting electronic circuit in a hermetically sealed hollow space.

In Example 10, the subject matter of Example 9 can optionally include wherein a layer thickness of metal oxides on the portion of the superconducting electronic circuit enclosed in the hermetically sealed hollow space is equal to or less than 1.0 nm or 0.5 nm or 0.3 nm.

In Example 11, the subject matter of Example 9 or 10 can optionally include wherein the superconducting electronic circuit comprises a resonating circuit and a readout circuitry, wherein the resonating circuit and the readout circuitry are enclosed in the hermetically sealed hollow space.

In Example 12, the subject matter of Example 9 or 10 can optionally include wherein the superconducting electronic circuit comprises a resonating circuit and a readout circuitry, wherein the resonating circuit is enclosed in the hermetically sealed hollow space and the readout circuitry is at least partly outside the hermetically sealed hollow space.

In Example 13, the subject matter of Example 11 or 12 can optionally include wherein the readout circuitry comprises a resonator coupled to the resonating circuit, in particular qubit.

In Example 14, the subject matter of any of Examples 9 to 13 can optionally include wherein the resonating circuit, in particular qubit, comprises a Josephson junction, a resonating circuit capacitor and a resonating circuit inductor.

In Example 15, the subject matter of any of Examples 9 to 14 can optionally include a further superconducting electronic circuit formed over the substrate; and a further lid enclosing at least a portion of the further superconducting electronic circuit in a further hermetically sealed hollow space, wherein the further lid is arranged aside the lid.

In Example 16, the subject matter of any of Examples 9 to 14 can optionally include a further superconducting electronic circuit formed at a level over the superconducting electronic circuit; and a further lid enclosing at least a portion of the further superconducting electronic circuit in a further hermetically sealed hollow space, wherein the further lid is disposed over the lid.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A method of manufacturing an electronic device, the method comprising:
generating a superconducting electronic circuit on a substrate;
removing metal oxides from metallizations of the superconducting electronic circuit in a process chamber with a substantially oxygen-free environment; and
in situ enclosing at least a portion of the superconducting electronic circuit in a hermetically sealed hollow space.

2. The method of claim 1, wherein throughout the whole period between the removal of the metal oxides and the in situ enclosing, the oxygen partial pressure of the environment is equal to or less than 10⁻⁷ or 10⁻⁸ mbar.

3. The method of claim 1 or 2, wherein removing the metal oxides comprises plasma etching, HF vapour application or wet etching.

4. The method of one of the preceding claims, further comprising:
generating a lid wafer comprising a plurality of integral lids;
in situ covering at least the portion of the superconducting electronic circuit by the lid wafer or a diced-out portion of the lid wafer to form the hermetically sealed hollow space; and
singulating the electronic device by dicing the lid wafer or diced-out portion of the lid wafer and the substrate.

5. The method of one of claims 1 to 3, further comprising:
forming a sacrificial material on the superconducting electronic circuit;
forming a lid layer on the sacrificial material;
removing the sacrificial material via at least one opening leading into the space between the substrate and the lid layer; and,
after removing the metal oxides from the metallizations of the superconducting electronic circuit in the substantially oxygen-free environment, closing the at least one opening in situ to provide the hermetically sealed hollow space.

6. The method of claim 5, wherein removing the sacrificial material and removing the metal oxides is performed by the same process.

7. The method of claim 5 or 6, further comprising:
depositing a planarization layer over the lid layer and the substrate;
planarizing the planarization layer; and
manufacturing a further electronic device over the planarization layer.

8. The method of claim 7, wherein the planarization layer is used as the substrate of the further electronic device.

9. An electronic device comprising:
a substrate;
a superconducting electronic circuit formed over the substrate; and
a lid enclosing at least a portion of the superconducting electronic circuit in a hermetically sealed hollow space.

10. The electronic device of claim 9, wherein a layer thickness of metal oxides on the portion of the superconducting electronic circuit enclosed in the hermetically sealed hollow space is equal to or less than 1.0 nm or 0.5 nm or 0.3 nm.

11. The electronic device of claim 9 or 10, wherein the superconducting electronic circuit comprises a resonating circuit and a readout circuitry, wherein the resonating circuit and the readout circuitry are enclosed in the hermetically sealed hollow space.

12. The electronic device of claim 9 or 10, wherein the superconducting electronic circuit comprises a resonating circuit and a readout circuitry, wherein the resonating circuit is enclosed in the hermetically sealed hollow space and the readout circuitry is at least partly outside the hermetically sealed hollow space.

13. The electronic device of claims 11 or 12, wherein the readout circuitry comprises a resonator coupled to the resonating circuit.

14. The electronic device of any of claims 10 to 13, wherein the resonating circuit comprises a Josephson junction and a resonating circuit capacitor.

15. The electronic device of any of claims 9 to 14, further comprising:
a further superconducting electronic circuit formed over the substrate; and
a further lid enclosing at least a portion of the further superconducting electronic circuit in a further hermetically sealed hollow space, wherein the further lid is arranged aside the lid.

16. The electronic device of any of claims 9 to 14, further comprising:
a further superconducting electronic circuit formed on a level over the superconducting electronic circuit; and
a further lid enclosing at least a portion of the further superconducting electronic circuit in a further hermetically sealed hollow space, wherein the further lid is disposed over the lid.
